(19) Europäisches Patentamt
European Patent Office
Office européen des brevets

(11) EP 2 189 967 A2

(12) EUROPEAN PATENT APPLICATION

(43) Date of publication:
26.05.2010 Bulletin 2010/21

(51) Int Cl.:
$G09G\ 3/32$ (2006.01)

(21) Application number: 09176239.3

(22) Date of filing: 17.11.2009

(84) Designated Contracting States:
AT BE BG CH CY CZ DE DK EE ES FI FR GB GR
HR HU IE IS IT LI LT LU LV MC MK MT NL NO PL
PT RO SE SI SK SM TR
Designated Extension States:
AL BA RS

(30) Priority: 24.11.2008 KR 20080116855

(71) Applicant: Samsung Mobile Display Co., Ltd.
Yongin-city, Gyunggi-do 446-711 (KR)

(72) Inventors:
• KANG, Ki-Nyeng
Gyeonggi-do (KR)
• SEO, Hae-Kawn
Gyeonggi-do (KR)
• YANG, Hui-Won
Gyeonggi-do (KR)

(74) Representative: Walaski, Jan Filip et al
Venner Shipley LLP
20 Little Britain
London
EC1A 7DH (GB)

(54) **Pixel and organic light emitting display device using the same**

(57) The present invention provides a pixel comprising: organic light emitting diodes emitting corresponding to the amount of a driving current; a first transistor whose first electrode is coupled to a first power supply, second electrode is coupled to the organic light emitting diodes, and gate is coupled to a first node, the first transistor forming the driving current corresponding to a voltage of the first node; a second transistor transferring data signals to the first node corresponding to a first scan signal; a third transistor applying a negative voltage to the first node corresponding to a second scan signal; and a capacitor maintaining the voltage of the first node, and an organic light emitting display device using the same.

FIG. 3

EP 2 189 967 A2

**Description**

The invention relates to a pixel and an organic light emitting display device using the same, and more particularly to a pixel using an oxide transistor, and an organic light emitting display device using the same.

Various flat panel display devices having reduced weight and volume when compared to a cathode ray tube have been developed. The flat panel display devices include a liquid crystal display (LCD) device, a field emission display (FED) device, a plasma display panel (PDP) device, an organic light emitting display (OLED) device, etc.

The organic light emitting display has various advantages including excellent colour reproducibility, slimness and the like so that its applications have largely expanded to PDAs, MP3 players, and the like, in addition to cellular phones.

The organic light emitting display device displays an image using organic light emitting diodes (OLED) expressing brightness of light emitted according to an amount of input current.

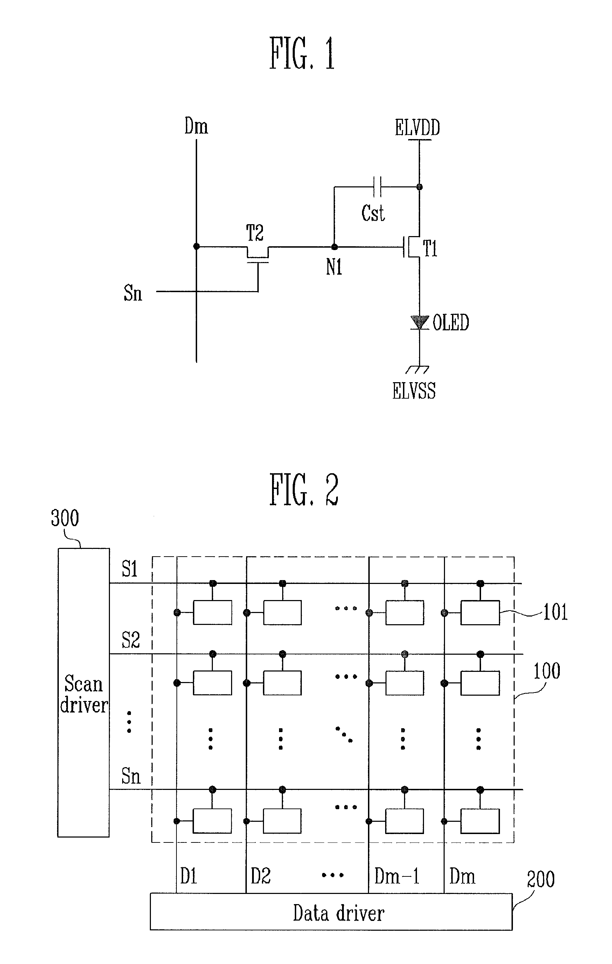

FIG. 1 is a circuit diagram of a pixel used in some organic light emitting display devices. Referring to FIG. 1, the pixel includes a first transistor T1, a second transistor T2, a capacitor Cst and an organic light emitting diode OLED.

The first transistor T1 has a source coupled to a first power supply ELVDD, a drain coupled to an anode electrode of the organic light emitting diode OLED, and a gate coupled to a first node N1.

The second transistor T2 has a source coupled to a data line Dm, a drain coupled to the first node N1, and a gate coupled to a scan line Sn.

The capacitor has a first electrode coupled to the first power supply ELVDD, and a second electrode coupled to the first node N1.

The organic light emitting diode OLED has an anode electrode coupled to the drain of the first transistor T1, and a cathode electrode coupled to a second power supply ELVSS.

The pixel of FIG. 1 determines the amount of current flowing to the organic light emitting diode OLED according to a voltage difference between the source and gate of the first transistor T1. In other words, the amount of current flowing to the organic light emitting diode corresponding to the voltage of the first power supply ELVDD and the data signals is approximated by the following equation 1.

$$I_{OLED} = \frac{\beta}{2}(V_{GS} - V_{th})^2 \qquad (\text{Eq. 1})$$

Herein, $I_{OLED}$ represents the amount of current flowing to the organic light emitting diode OLED, $V_{GS}$ represents a voltage difference between the source and gate of the first transistor T1, and $V_{th}$ represents a threshold voltage of the first transistor T1.

Therefore, the current flowing to the organic light emitting diode OLED is affected by the threshold voltage of the first transistor T1.

If transistor T1 is an oxide transistor and the gate of the transistor T1 is maintained with a higher voltage than the source thereof, the transistor is deteriorated such that the threshold voltage increases.

Such a deterioration phenomenon causes unexpected current to flow to the organic light emitting diode OLED, and accordingly the organic light emitting diode emits light such that afterimages are formed. Such a deterioration phenomenon becomes greater as the voltage of the gate of the transistor is greater and the stress time is longer.

With the problems as described above, it is problematic to form the pixel of the organic light emitting display device using the oxide transistor.

One aspect is a pixel including an organic light emitting diode configured to emit light according to an amount of a driving current, a first transistor, including a first electrode coupled to a first power supply, a second electrode coupled to the organic light emitting diode, and a gate coupled to a first node, where the first transistor conducts the driving current according to a voltage of the first node, a second transistor configured to transmit data signals to the first node according to a first scan signal, a third transistor configured to apply a discharge voltage to the first node according to a second scan signal, and a capacitor configured to maintain the voltage of the first node.

Another aspect is an organic light emitting display device including a pixel unit configured to display an image in response to data signals and scan signals, a data driver configured to generate the data signals, and a scan driver configured to generate the scan signals, where the pixel unit includes a plurality of pixels, each pixel including an organic light emitting diode configured to emit light according to an amount of a driving current, a first transistor, including a first electrode coupled to a first power supply, a second electrode coupled to the organic light emitting diode, and a gate coupled to a first node, where the first transistor conducts the driving current according to a voltage of the first node, a second transistor configured to transmit data signals to the first node according to a first scan signal, a third transistor configured to apply a discharge voltage to the first node according to a second scan signal, and a capacitor configured to maintain the voltage of the first node.

Another aspect is a method of driving an organic light emitting display device, which displays an image by controlling amounts of currents flowing from a plurality of transistors to a plurality of organic light emitting diodes, the method including applying a data signal to the gate of one of the transistors according to a first scan signal, applying a discharge voltage to the gate of the one transistor according to a second scan signal.

The accompanying drawings, together with the specification, illustrate exemplary embodiments, and, together with the description, serve to explain various inventive aspects.

FIG. 1 is a circuit diagram of a pixel used in an organic light emitting display device;

FIG. 2 is a block diagram of an organic light emitting display device;

FIG. 3 is a circuit diagram of one embodiment of a pixel for the organic light emitting display device of FIG.2;

FIG. 4 is a waveform view of signals input to the pixel of FIG. 3;

FIG. 5 is a circuit diagram of an embodiment of a pixel for the organic light emitting display device of FIG.2;

FIG. 6 is a waveform view of signals input to the pixel of FIG. 5;

FIG. 7 is a circuit diagram of an embodiment of a pixel for the organic light emitting display device of FIG.2; and

FIG. 8 is a circuit diagram of another embodiment of a pixel for the organic light emitting display device of FIG.2.

Some embodiments provide a pixel using an oxide transistor, and an organic light emitting display device using the same. With the pixel and the organic light emitting display device, the deterioration of the transistor is prevented by discharging the transistor, making it possible to implement the pixel using the oxide transistor.

Hereinafter, certain exemplary embodiments will be described with reference to the accompanying drawings. Here, when a first element is describes as being coupled to a second element, the first element may be directly coupled to the second element or may be indirectly coupled to the second element via a third element. Further, some of the elements that are not essential to the complete understanding of the invention may be omitted for clarity. Also, like reference numerals generally refer to like elements throughout.

FIG. 2 is a structure view of an organic light emitting display device, which includes a pixel unit 100, a data driver 200, and a scan driver 300.

The pixel unit 100 is arranged with a plurality of pixels 101, wherein each pixel 101 includes an organic light emitting diode (not shown) configured to emit light according to the flow of current therethrough. In addition, the pixel unit 100 has n scan lines S1, S2, ... Sn-1, and Sn formed in a row direction and configured to transmit scan signals, and m data lines D1, D2, ... Dm-1, and Dm formed in a column direction and configured to transmit data signals.

Also, the pixel unit 100 is driven by receiving first power (not shown) and second power (not shown) having a lower voltage level than the first power. The pixel units 100 emit light by allowing a current to flow in their organic light emitting diodes according to the scan signals, the data signals, the first power, and the second power, thereby displaying an image.

Also, pixel unit 100 includes wires (not shown) for applying a negative supply capable of discharging charges in each pixel 101.

In some embodiments, the data driver 200, which is a means generating data signals, generates data signals using image signals having red, blue and green components. The data driver 200 applies the generated data signals to the data lines D1, D2, ... Dm-1, and Dm of the pixel unit 100.

In some embodiments, the scan driver 300, which is a means generating scan signals, is coupled to scan lines S1, S2, .... Sn-1, and Sn to transfer scan signals to a specific row of the pixel unit 100. The data signals output from the data driver 200 are transmitted to the pixel 101 with the scan signals so that a voltage corresponding to a data signal is transferred to the pixel 101.

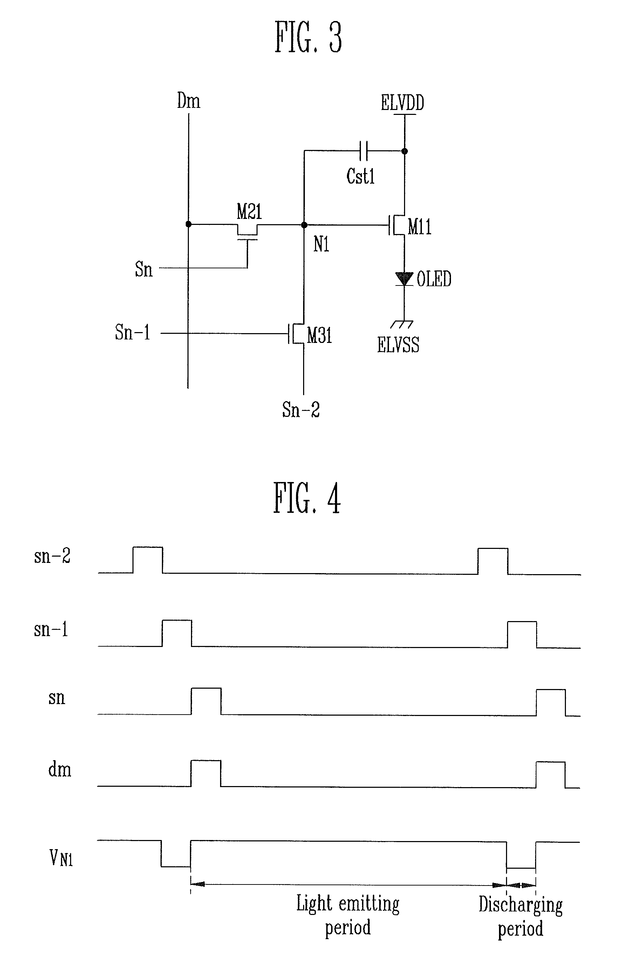

FIG. 3 is a circuit diagram of one embodiment of a pixel for use in the organic light emitting display device of FIG.2.

Referring to FIG. 3, the pixel includes a first transistor M11, a second transistor M21, a third transistor M31, a capacitor Cst and an organic light emitting diode OLED. Also, in this embodiment, each transistor is implemented as an NMOS oxide transistor. In other embodiments corresponding PMOS transistors are used.

The first transistor M11 allows a driving current to flow from a first power supply ELVDD to a second power supply ELVSS, wherein the amount of the driving current is determined according to the voltage applied to the gate of the first transistor M11. The first transistor M11 has a source coupled to the first power supply ELVDD, a drain coupled to an anode electrode of the organic light emitting diode OLED, and a gate coupled to a first node N1.

The second transistor M21 allows data signals to be selectively transferred to the gate of the first transistor M11. The second transistor M21 has a source coupled to a data line Dm, a drain coupled to the first node N1, and a gate coupled to a first scan line Sn.

The third transistor M31 is used to discharge the gate of the first transistor M11. The third transistor M31 has a source coupled to a second scan line Sn-2, a drain coupled to the first node N1, and a gate coupled to a third scan line Sn-1.

The capacitor Cst1 allows the gate voltage of the first transistor M11 to be maintained. The capacitor Cst1 has a first electrode coupled to the first power supply ELVDD, and a second electrode coupled to the first node N1.

The organic light emitting diode OLED emits light as a result of receiving a driving current. The organic light emitting diode OLED has an anode electrode coupled to the drain of the first transistor M11, and a cathode electrode coupled to the second power supply ELVSS.

FIG. 4 is a waveform view of signals input to the pixel of FIG. 3.

Referring to FIG. 4, when the second previous scan signal Sn-2 changes from a high state to a low state, and the previous scan signal Sn-1 changes from a low state to a high state, the third transistor M31 is turned on. As a result, the voltage $V_{N1}$ of first node N1 receives the scan signal Sn-2, which is in a low state. Therefore, the charge at the gate of the first transistor M11 is removed by the second scan signal Sn-2. In other words, the interface trap charge is reduced. Through the operation as described above, it is possible to suppress the phenomenon that the threshold voltage of the first transistor M11 is increased.

When the previous scan signal Sn-1 changes from a high state to a low state, and the first scan signal Sn transferred through the current scan line Sn changes from a low state to a high state, the second transistor M21 is turned on, and the third transistor M31 is turned off. Therefore, the data signal flows to the first node N1 through the data line Dm, and the voltage $V_{N1}$ of the first node N1 corresponds to the voltage of data signal. The first node N1 maintains the voltage of the data signal with the capacitor Cst.

Therefore, current corresponding to the current of data signal flows from the source to the drain of the first transistor M11 and to the organic light emitting diode OLED, such that the pixel emits light.

As shown in FIG. 4, the duration of the light emitting period is longer than the duration of the discharging period.

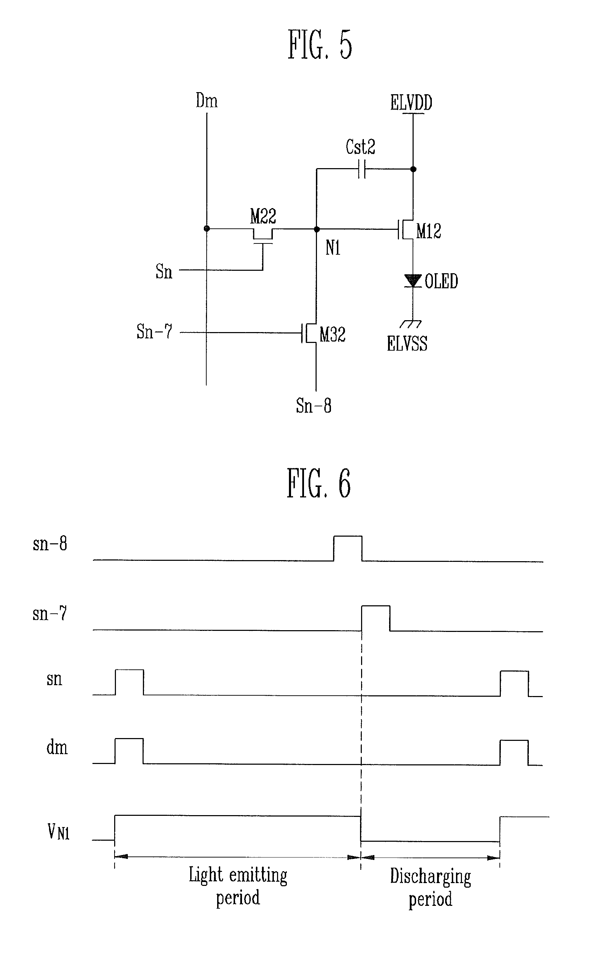

FIG. 5 is a circuit diagram of another embodiment of a pixel for use in the organic light emitting display device of FIG.2. Referring to FIG. 5, the pixel includes a first transistor M12, a second transistor M22, a third transistor M32, a capacitor Cst2 and an organic light emitting diode OLED. Each transistor is implemented as an NMOS oxide transistor, however, in other embodiments PMOS devices may alternatively be used.

The first transistor M12 allows a driving current to flow from a first power supply ELVDD to a second power supply ELVSS, wherein the amount of the driving current corresponds to the voltage applied to the gate of the first transistor M12. The first transistor M12 has a source coupled to the first power supply ELVDD, a drain coupled to an anode electrode of the organic light emitting diode OLED, and a gate coupled to a first node N1.

The second transistor M22 allows data signals to be selectively transferred to the gate of the first transistor. The second transistor M22 has a source coupled to a data line Dm, a drain coupled to the first node N1, and a gate coupled to a first scan line Sn.

The third transistor M32 is used to discharge the gate of the first transistor M12. The third transistor M32 has a source coupled to an eighth previous scan line Sn-8, a drain coupled to the first node N1, and a gate coupled to a seventh previous scan line Sn-7.

The capacitor Cst2 allows the gate voltage of the first transistor M12 to be maintained. The capacitor Cst2 has a first electrode coupled to the first power supply ELVDD, and a second electrode coupled to the first node N1.

The organic light emitting diode OLED emits light in response to receiving a driving current. The organic light emitting diode OLED has an anode electrode coupled to the drain of the first transistor M12, and a cathode electrode coupled to the second power supply ELVSS.

FIG. 6 is a waveform view of signals input to the pixel of FIG. 5.

Referring to FIG. 6, when the eighth previous scan signal Sn-8 changes from a high state to a low state, and the seventh previous scan signals Sn-7 changes from a low state to a high state, the third transistor M32 is turned on. As a result, the voltage $V_{N1}$ of first node N1 becomes low. Therefore, the charge at the gate of the first transistor M12 is removed by the eighth previous scan signal Sn-8. Consequently, the interface trap charge is reduced. Through the operation as described above, it is possible to suppress the phenomenon that the threshold voltage of the first transistor M12 increases with age.

When the seventh previous scan signal Sn-7 changes from a high state to a low state and the current scan signal Sn changes from a low state to a high state, the second transistor M22 is turned on and the third transistor M32 is turned off. Therefore, the data signal is provided to the first node N1 through the data line Dm. At this time, the first node N1 maintains the voltage of data signal with the capacitor Cst2.

As a result, current corresponding to the data signal flows from the source to the drain of the first transistor M12 and to the organic light emitting diode OLED.

As shown in FIG. 6, the duration of the light emitting period is similar to the duration of the discharging period.

Comparison of the embodiments of FIGs. 3 and 5 shows that the relative durations of the light emitting and discharging periods is determined by which scan signals are used to discharge the gate of the first transistor. Accordingly, the scan signals to use can be selected to achieve a desired relative duration.

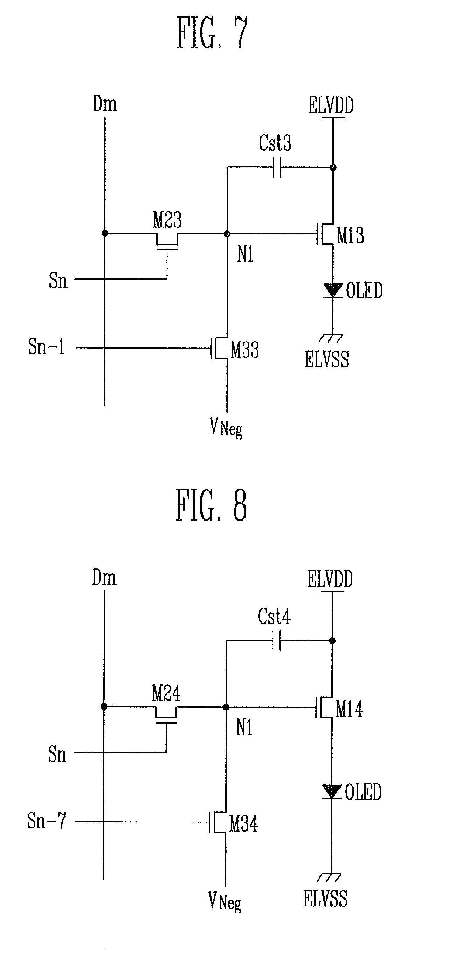

FIG. 7 is a circuit diagram of an embodiment of a pixel for use in the organic light emitting display device of FIG.2. Referring to FIG. 7, the pixel includes a first transistor M13, a second transistor M23, a third transistor M33, a capacitor Cst3 and an organic light emitting diode OLED. Also, in this embodiment, each transistor is implemented as an NMOS oxide transistor, however PMOS transistors can also be used.

The first transistor M13 allows a driving current to flow from a first power supply ELVDD to a second power supply ELVSS, wherein the amount of driving current corresponds to the voltage applied to the gate of the first transistor M13. The first transistor M13 has a source coupled to the first power supply ELVDD, a drain coupled to an anode electrode of the organic light emitting diode OLED, and a gate coupled to a first node N1.

The second transistor M23 allows data signals to be transferred selectively to the gate of the first transistor. The second transistor M23 has a source coupled to a data line Dm, a drain coupled to the first node N1, and a gate coupled to a first scan line Sn.

The third transistor M33 is used to discharge the gate of the first transistor M13. The third transistor M33 has a source coupled to a negative supply voltage Vneg, a drain coupled to the first node N1, and a gate coupled to the previous scan line Sn-1. According to the voltage at the previous scan line Sn-1, negative voltage Vneg is selectively transferred to the first node N1 to discharge the first node N1 and the capacitor Cst3.

The capacitor Cst3 allows the gate voltage of the first transistor M13 to be maintained. The capacitor Cst3 has a first electrode coupled to the first power supply ELVDD, and a second electrode coupled to the first node N1.

The organic light emitting diode OLED emits light in response to receiving a driving current. The organic light emitting diode OLED has an anode electrode coupled to the drain of the first transistor M13, and a cathode electrode coupled to the second power supply ELVSS.

FIG. 8 is a circuit diagram of another embodiment of a pixel for use in the organic light emitting display device of FIG.2. Referring to FIG. 8, the pixel includes a first transistor M14, a second transistor M24, a third transistor M34, a capacitor Cst4 and an organic light emitting diode OLED. Also, each transistor is implemented as an NMOS oxide transistor, although PMOS devices may alternatively be used.

The first transistor M14 allows a driving current to flow from a first power supply ELVDD to a second power supply ELVSS, wherein the amount of the driving current corresponds to the voltage applied between the gate and source of the first transistor M14. The first transistor M14 has a source coupled to the first power supply ELVDD, a drain coupled to an anode electrode of the organic light emitting diode OLED, and a gate coupled to a first node N1.

The second transistor M24 allows data signals to be selectively transferred to the gate of the first transistor 14. The second transistor M24 has a source coupled to a data line Dm, a drain coupled to the first node N1, and a gate coupled to a first scan line Sn.

The third transistor M34 is used to discharge the first node N1. The third transistor M34 has a source coupled to a negative voltage Vneg, a drain coupled to the first node N1, and a gate coupled to a seventh previous scan line Sn-7. Accordingly, the negative voltage Vneg is transferred to the pixel according to the voltage of the seventh previous scan line Sn-7.

The capacitor Cst4 allows the gate voltage of the first transistor M13 to be maintained. The capacitor Cst4 has a first electrode coupled to the first power supply ELVDD, and a second electrode coupled to the first node N1.

The organic light emitting diode OLED emits light in response to receiving the driving current. The organic light emitting diode OLED has an anode electrode coupled to the drain of the first transistor M14, and a cathode electrode coupled to the second power supply ELVSS.

While certain embodiments have been described, it is to be understood that the invention is not limited to the disclosed embodiments, but, on the contrary, is intended to cover various modifications and equivalent arrangements falling within the scope of the appended claims.

## Claims

1.    A pixel comprising:

an organic light emitting diode configured to emit light in response to a driving current;
a first transistor (M11 - M14) comprising:

a first electrode coupled to a first power supply (ELVDD);
a second electrode coupled to the organic light emitting diode; and
a gate coupled to a first node (N1),
wherein the first transistor conducts the driving current according to a voltage of the first node;

a second transistor (M21 - M24) configured to transmit data signals to the first node according to a first scan signal (Sn);
a third transistor (M31 - M34) configured to apply a discharge voltage (Sn-2, Sn-8, Vneg) to the first node according to a second scan signal (Sn-1, Sn-7); and
a capacitor (Cst1 - Cst4) configured to maintain the voltage of the first node.

2.    The pixel as claimed in claim 1, wherein the discharge voltage is a voltage of a third scan signal (Sn-2, Sn-8).

3.    The pixel as claimed in claim 2, wherein the first scan signal is a scan signal (Sn) transmitted to an $n^{th}$ scan line, the second scan signal is a scan signal (Sn-1) transmitted to an $n-1^{th}$ scan line, and the third scan signal is a scan signal (Sn-2) transmitted to an $n-2^{th}$ scan line.

4.    The pixel as claimed in claim 2, wherein the first scan signal is a scan signal (Sn) transmitted to an $n^{th}$ scan line, and the second scan signal and the third scan signal are scan signals that change to a high state after a period of time after the first scan signal changes to a high state.

**5.** The pixel as claimed in any one of the preceding claims, wherein a time during which the data signal and the discharge voltage are transmitted to the first node corresponds to the first scan signal and the second scan signal, respectively.

**6.** The pixel as claimed in any one of the preceding claims, wherein the transistors are oxide transistors.

**7.** The pixel as claimed in claim 1, wherein the discharge voltage is a supply voltage (Vneg).

**8.** The pixel as claimed in claim 7, wherein the third transistor (M31 - M34) is connected to the supply voltage.

**9.** The pixel as claimed in any one of the preceding claims, wherein the capacitor (Cst1 - Cst4) is connected to the first power supply (ELVDD).

**10.** The pixel as claimed in any one of the preceding claims, wherein a first electrode of the second transistor is connected to the first node, a second electrode of the second transistor is connected to a data line and the gate electrode of the second transistor is connected to the first scan signal.

**11.** The pixel as claimed in any one of the preceding claims, wherein a first electrode of the third transistor is connected to the first node, a second electrode of the third transistor is connected to the discharge voltage and the gate electrode of the third transistor is connected to the second scan signal.

**12.** An organic light emitting display device comprising:

a pixel unit configured to display an image in response to data signals and scan signals;
a data driver configured to generate the data signals; and
a scan driver configured to generate the scan signals,
wherein the pixel unit comprises a plurality of pixels, each pixel comprising a pixel as claimed in any one of the preceding claims.

**13.** A method of driving an organic light emitting display device according to claim 12, which displays an image by controlling amounts of currents flowing from a plurality of transistors to a plurality of organic light emitting diodes, the method comprising:

applying a data signal to the gate of one of the transistors according to a first scan signal;
applying a discharge voltage to the gate of the one transistor according to a second scan signal.

**14.** The method of driving the organic light emitting display device as claimed in claim 13, wherein the discharge voltage applied to the gate is a voltage of a scan signal transferred to an $n\text{-}2^{th}$ scan line, and the discharge voltage is applied in response to an $n\text{-}1^{th}$ scan signal, and the data signal is applied to the gate by an $n^{th}$ scan signal.

**15.** The method of driving the organic light emitting display device as claimed in claim 13, wherein the discharge voltage is a scan signal that changes to a high state after a predetermined period of time after the $n^{th}$ scan signal changes to a high state.

# FIG. 1

Dm

ELVDD

Cst

T2

T1

Sn

N1

OLED

ELVSS

# FIG. 2

300

S1

101

Scan
driver

S2

100

Sn

D1    D2    ...    Dm-1    Dm

200

Data driver

# FIG. 3

# FIG. 4

Light emitting period

Discharging period

# FIG. 5

# FIG. 6

# FIG. 7

Dm    ELVDD

Cst3

M23    M13

N1    OLED

Sn

Sn-1    M33    ELVSS

VNeg

# FIG. 8

Dm    ELVDD

Cst4

M24    M14

N1    OLED

Sn

Sn-7    M34    ELVSS

VNeg